# EUROPEAN PATENT SPECIFICATION

(11) **EP 4 303 916 B1**
(45) Date of publication and mention of the grant of the patent: **28.01.2026**
(21) Application number: 21929087.1
(22) Date of filing: 05.03.2021
(51) Int. Cl.: H01L 23/48, H01L 25/07, H01L 25/18, H01L 23/495, H02M 7/00, H01L 21/48, H01L 23/31

(54) **SEMICONDUCTOR MODULE**
HALBLEITERMODUL
MODULE À SEMI-CONDUCTEURS

(43) Date of publication of application: 10.01.2024
(73) Proprietor: MITSUBISHI ELECTRIC CORPORATION, Chiyoda-ku Tokyo 100-8310 (JP)
(72) Inventor: TAKEUCHI, Kensuke, Tokyo 102-0073 (JP)
(74) Representative: Hoffmann Eitle
(86) International application number: PCT/JP2021/008614
(87) International publication number: WO 2022/185515

(56) References cited:
- JP-A- 2001 177 037
- JP-A- 2001 177 037
- JP-A- 2005 072 266
- JP-A- 2005 072 266
- JP-A- H0 439 958
- JP-A- H0 567 724
- JP-A- H0 661 412
- JP-A- H05 152 485
- JP-A- H06 104 374
- JP-Y2- H0 635 476
- US-A- 5 471 097
- US-A1- 2007 096 278
- US-A1- 2015 332 992

## Description

### [Technical Field]

The present disclosure relates to a semiconductor module.

### [Background Art]

A conventional semiconductor module is described in Patent Literatures 1 and 2. Such a semiconductor module includes, for example, a plurality of terminals, a plurality of semiconductor switching elements, a wirings connecting between the terminals, a wiring connecting the terminal and the semiconductor switching element, or the like. The plurality of the terminals are, for example, a positive-pole power supply terminal, a negative-pole power supply terminal, an output terminal (load terminal), a control terminal, or the like.

In Patent Literature 1, a three-dimensional structure having a control terminal and a power terminal which are bent is described. In Patent Literature 2, a member that is formed around a terminal and made of a high thermal conductive resin is described.

### [Citation List]

### [Patent Document]

[Patent Document 1]
   Japanese Patent No. 4336713
[Patent Document 2]
Document US 5 471 097 relates to a semiconductor device encapsulated with a synthetic resin portion, that includes a semiconductor chip, a plurality of leads each electrically connected at one end thereof to the semiconductor chip and bent to have a gull-wing like shape extending outwardly from the synthetic resin portion, and an insulating support member provided in a flat portion nearer to the resin portion than a bottom soldering face of the leads of the gull-wing like shape. The leads are fixed to each other by means of the insulating support member.

### [Summary of Invention]

### [Technical Problem]

In the structure of Patent Literatures 1 and 2, there is a problem in that positional displacement or deformation of a terminal occurs due to warpage, deformation, or spring back of the terminal generated on a resin mold.

The present disclosure was made in order to solve the above problem and has an object to provide a semiconductor module which can suppress positional displacement or deformation of a terminal.

### [Solution to Problem]

A semiconductor module is disclosed as recited in claim 1.

### [Advantageous Effects of Invention]

According to the present disclosure, it is possible to provide a semiconductor module which can suppress positional displacement or deformation of a terminal.

### [Brief Description of Drawings]

FIG. 1 is a circuit diagram showing an overall structure of a vehicle electric power steering device including a semiconductor module according to a first embodiment.
FIG. 2 is a plan view showing is an inner structure of the semiconductor module according to a modification of the first embodiment not falling within the scope of the invention.
FIG. 3 is a perspective view showing the semiconductor module according to a modification of the first embodiment according to the invention.
FIG. 4A is a plan view showing a relevant part of the semiconductor module according to a modification of the first embodiment according to the invention.
FIG. 4B is a plan view showing a relevant part of the semiconductor module according to a modification of the first embodiment according to the invention.
FIG. 4C is an enlarged cross-sectional view showing a relevant part of the semiconductor module according to a modification of the first embodiment according to the invention.
FIG. 5A is an enlarged cross-sectional view showing a relevant part of the semiconductor module according to the first embodiment and showing a step of bending terminals.
FIG. 5B is an enlarged cross-sectional view showing a relevant part of the semiconductor module according to the first embodiment and showing a step of bending terminals.
FIG. 6A is a plan view showing a semiconductor module according to a modified example of the first embodiment not falling within the scope of the invention.
FIG. 6B is a side view showing the semiconductor module according to the modified example of the first embodiment.
FIG. 7 is a perspective view showing a semiconductor module according to a second embodiment not falling within the scope of the invention.
FIG. 8 is a perspective view showing a semiconductor module according to a third embodiment according to the invention.

### [Description of Embodiments]

### First Embodiment

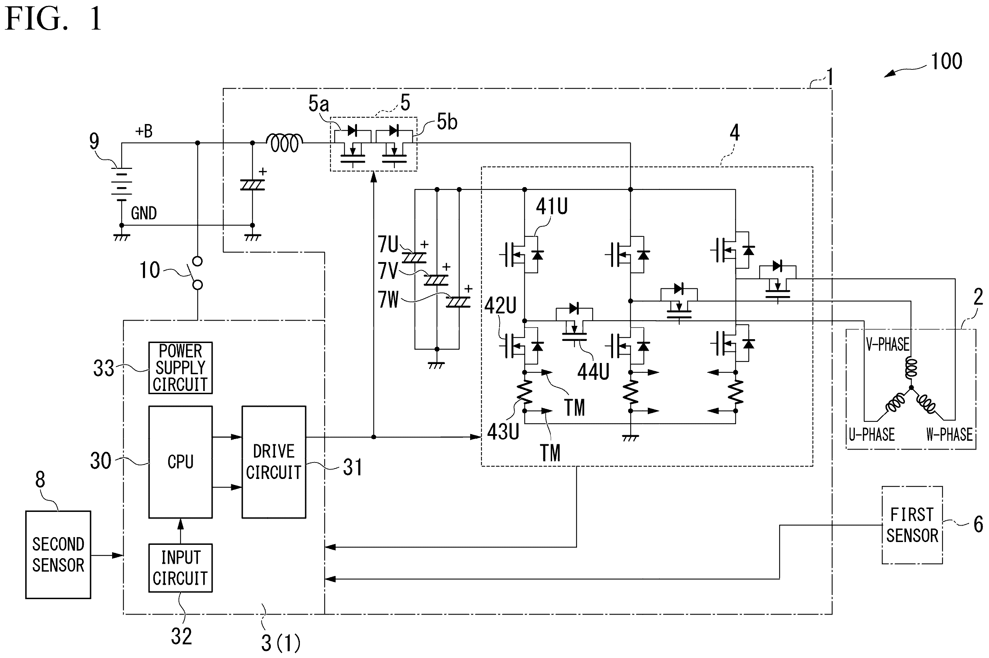

FIG. 1 is a circuit diagram showing an overall structure (system overall structure) of a vehicle electric power steering device including a semiconductor module according to a first embodiment.

The vehicle electric power steering device 100 includes, for example, a control unit 1, a motor 2, a first sensor 6, a second sensor 8, a battery 9 (power supply), an ignition switch 10, or the like.

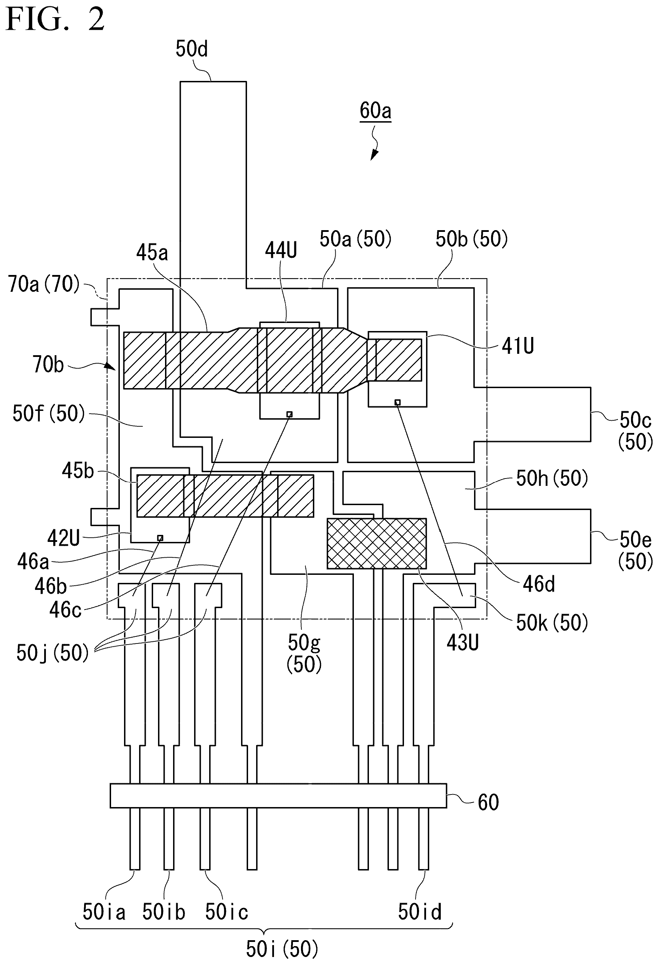

The control unit 1 includes a semiconductor module 60a (refer to FIG. 2, described hereinbelow) including a plurality of semiconductor switching elements built therein.

The control unit 1 includes, for example, a control circuit 3, an inverter circuit a power relay 5, capacitors 7U, 7V, and 7W, or the like.

The control circuit 3 is connected to the battery 9 with the ignition switch 10 interposed therebetween. The control circuit 3 includes, for example, a CPU 30, a drive circuit 31, an input circuit 32, and a power supply circuit 33.

The power relay 5 is disposed at an upstream side of the inverter circuit 4, that is, disposed between the inverter circuit 4 and the battery 9. The power relay 5 includes two switching elements 5a and 5b connected in series to each other. The power relay 5 has a relay function of connecting or cutting off between the battery 9 and the inverter circuit 4. That is, the power relay 5 carries out switching power supply to the inverter circuit 4.

The capacitors 7U, 7V, and 7W are smoothing capacitors and are arranged parallel to each other. Each of the capacitors 7U, 7V, and 7W is connected between a positive electrode and a ground (a negative electrode) of the battery 9.

The inverter circuit 4 supplies a current to a winding of the motor 2.

The inverter circuit 4 includes a plurality of switching elements (semiconductor switching element). The power relay 5 is connected to the battery 9. The inverter circuit 4 includes three bridge circuits corresponding to three-phase windings (U-phase, V-phase, and W-phase) constituting the motor 2.

The three phases are configured by the same circuit as each other. In the following explanation, one of phases (the U-phase) will be described, and explanation regarding the V-phase and the W-phase is omitted.

In the inverter circuit 4, a high-potential-side switching element 41U and a low-potential-side switching element 42U are connected in series. A relay switching element 44U is connected to an intermediate connection portion located between the high-potential-side switching element 41U and the low-potential-side switching element 42U. The relay switching element 44U has a relay function of connecting or cutting off between a coil of the motor 2 and the inverter circuit 4 in accordance with a load applied to the coil of the motor 2 or an output from the coil.

A shunt resistance 43U that detects current is connected to the downstream side of the low-potential-side switching element 42U (on the opposite side of the high-potential-side switching element 41U).

An end terminal group TM is provided at both ends of the shunt resistance 43U. The end terminal group TM is used to detect difference in electrical potential between both ends of the shunt resistance 43U and convert it into a current value. A monitor terminal used to detect a state of the inverter circuit 4 (monitor signal) is provided at the inverter circuit 4. The monitor signal is transmitted to the CPU 30 via the input circuit 32 of the control circuit 3.

The motor 2 is a brushless motor including three phase windings (U-phase, V-phase, and W-phase). The U-phase winding, the V-phase winding, and the W-phase winding correspond to the three bridge circuits of the inverter circuit 4.

The first sensor 6 is a rotation sensor that detects a rotation angle of a motor and is disposed adjacent to the motor 2. A rotation angle signal detected by the first sensor 6 is output from the first sensor 6 and is input to the control circuit 3.

The second sensor 8 is a torque sensor that detects steering force of the steering wheel, a vehicle speed sensor that detects a speed of a vehicle, or the like. The signal detected by the second sensor 8 is output from the second sensor 8 and is input to the control circuit 3.

The CPU 30 of the control circuit 3 calculates a current value necessary for rotation of the motor 2 and outputs a control signal based on the calculation result to the drive circuit 31. The drive circuit 31 drives each of the plurality of the switching elements constituting the inverter circuit 4.

The inverter circuit 4 detects electrical current and outputs a current detection signal to the control circuit 3. The current detection signal is input to the control circuit 3, the control circuit 3 carries out feedback control between the control circuit 3 and the inverter circuit 4.

All of the switching elements described above are controlled by an output signal of the drive circuit 31 in accordance with a command of the CPU 30.

Note that, the circuit built in the semiconductor module 60a constituting the control unit 1 is not limited to the configuration shown in FIG. 1. For example, the number of the bridge circuits of the inverter circuit 4 built in the semiconductor module 60a may be one to three or greater than or equal to four. Furthermore, a circuit excluding the power relay 5, a circuit excluding the shunt resistance 43U, a circuit excluding a part of the switching elements, or the like, may be built in the semiconductor module 60a.

### (Semiconductor Module)

FIG. 2 is a plan view showing an inner structure of the semiconductor module 60a. In FIG. 2, a resin mold 70 is omitted in the drawing in order to explain the inner structure of the semiconductor module 60a, and an outer-periphery 70a of the resin mold 70 is shown by a dashed-two dotted line.

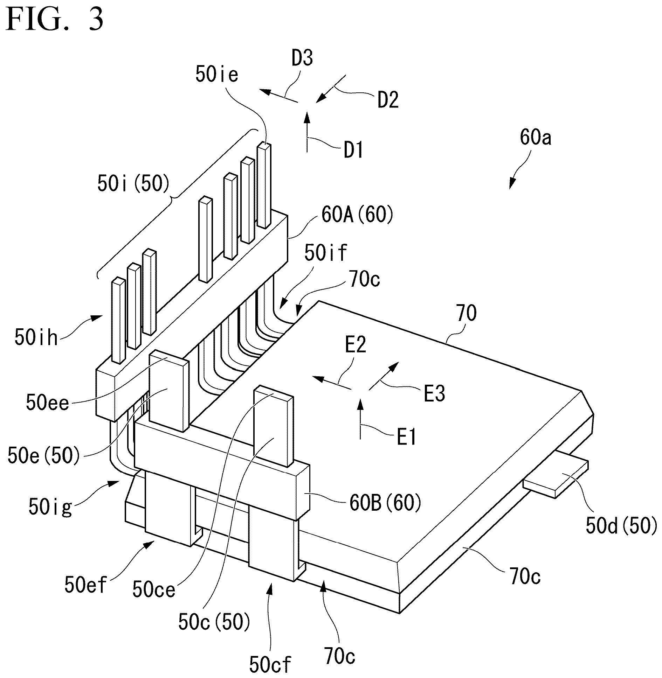

FIG. 3 is a perspective view showing the semiconductor module 60a.

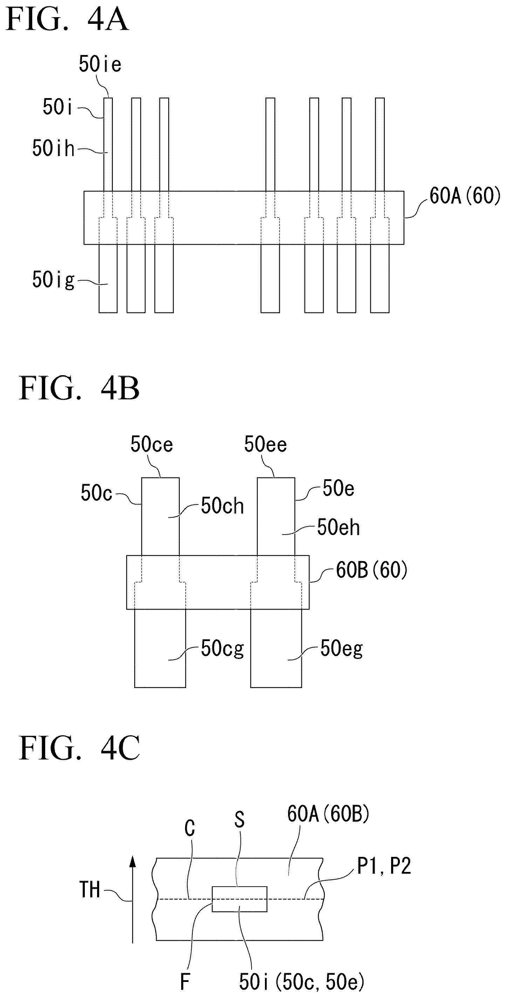

FIG. 4A is a plan view showing a relevant part of the semiconductor module 60a and is an explanatory view showing a structure of a control terminal 50i.

FIG. 4B is a plan view showing a relevant part of the semiconductor module 60a and is an explanatory view showing a structure of power terminals 50c and 50e.

FIG. 4C is an enlarged cross-sectional view showing a relevant part of the semiconductor module 60a and an explanatory view showing a positional relationship between a first support member 60A and the control terminal 50i and a positional relationship between a second support member 60B and the power terminals 50c and 50e.

The semiconductor module 60a includes the high-potential-side switching element 41U (semiconductor switching element), the low-potential-side switching element 42U (semiconductor switching element), the shunt resistance 43U, the relay switching element 44U (semiconductor switching element), the resin mold 70, and a terminal member 50.

### (Resin Mold)

The resin mold 70 is formed so as to cover the entirety of the semiconductor module 60a. The resin mold 70 encloses the switching elements 41U, 42U, and 44U, and the shunt resistance 43U. In other words, the switching elements 41U, 42U, and 44U, and the shunt resistance 43U are disposed in a region 70b provided at the inside of the outer-periphery 70a of the resin mold 70.

A known resin is used for a constituent material of the resin mold 70, and the type of materials is not limited. The resin mold 70 is formed by molding a resin only on one surface of the terminal member 50.

### (Terminal Member)

The terminal member 50 includes inner terminals 50a, 50b, 50f, 50g, 50h, 50j, and 50k which are disposed inside the resin mold 70, the plurality of the power terminals 50c, 50d, and 50e (outer terminal) which are disposed outside the resin mold 70, and a plurality of control terminals 50i (outer terminal).

The inner terminal 50a is connected to the relay switching element 44U. The inner terminal 50b is connected to the high-potential-side switching element 41U. The inner terminal 50f is connected to the low-potential-side switching element 42U. The inner terminals 50g, 50h, 50j, and 50k are connected to the control terminals 50i.

The plurality of the power terminals 50c, 50d, and 50e and the plurality of the control terminals 50i protrude from a side surface 70c of the resin mold 70 (refer to FIG. 3). In other words, the power terminals 50c, 50d, and 50e and the control terminals 50i are drawn out from the resin mold 70.

Connection wirings 45a, 45b, 46a, 46b, 46c, and 46d are provided inside the resin mold 70.

The connection wiring 45a electrically connects the high-potential-side switching element 41U, the relay switching element 44U, and the inner terminal 50f.

The connection wiring 45b electrically connects the low-potential-side switching element 42U and the inner terminal 50g.

The connection wiring 46a electrically connects the low-potential-side switching element 42U and a first control terminal 50ia serving as one of the plurality of the control terminals 50i.

The connection wiring 46b electrically connects the inner terminal 50a and a second control terminal 50ib serving as one of the plurality of the control terminals 50i.

The connection wiring 46c electrically connects the relay switching element 44U and a third control terminal 50ic serving as one of the plurality of the control terminals 50i.

The connection wiring 46d electrically connects the high-potential-side switching element 41U and a fourth control terminal 50id serving as one of the plurality of the control terminals 50i.

The shunt resistance 43U electrically connects the inner terminal 50g and the inner terminal 50g.

### (Support Member)

As shown in FIG. 3, the semiconductor module 60a includes a support member 60. At the outside of the resin mold 70, the support member 60 fixes the power terminals 50c and 50e and the control terminals 50i drawn out from the side surface 70c of the resin mold 70.

Specifically, the support member 60 includes the first support member 60A that fixes the plurality of the control terminals 50i and the second support member 60B that fixes the power terminals 50c and 50e. A known resin is used for a constituent material of the first support member 60A and the second support member 60B, and the type of materials is not limited.

### (First Support Member)

The first support member 60A is disposed at a position apart from the side surface 70c of the resin mold 70 and extends in a direction in which the plurality of the control terminals 50i are arrayed. That is, the first support member 60A extends in a direction substantially perpendicularly crossing to a direction in which each of the plurality of the control terminals 50i extends. The first support member 60A covers part of the outer-periphery of each of the plurality of the control terminals 50i, and fixes the plurality of the control terminals 50i such that the plurality of the control terminals 50i are spaced from each other. In other words, the first support member 60A bundles the plurality of the control terminals 50i and maintains the distance between the control terminals 50i adjacent to each other.

Each of the plurality of the control terminals 50i has an end portion 50ie located on the opposite side of the side surface 70c of the resin mold 70. The first support member 60A is disposed closer to the end portion 50ie than the side surface 70c of the resin mold 70.

Each of the plurality of the control terminals 50i has a bent portion 50if located between the side surface 70c of the resin mold 70 and the first support member 60A.

As shown in FIG. 4A, each of the plurality of the control terminals 50i has: a first terminal portion 50ig protruding from the side surface 70c of the resin mold 70; and a second terminal portion 50ih having the end portion 50ie. The second terminal portion 50ih is continuous to the first terminal portion 50ig. The second terminal portion 50ih has a width smaller than the width of the first terminal portion 50ig in the direction in which the plurality of the control terminals 50i are arrayed.

The first support member 60A covers part of the outer-periphery of the second terminal portion 50ih, and fixes the second terminal portion 50ih. The first support member 60A is disposed at a boundary between the first terminal portion 50ig and the second terminal portion 50ih. In other words, the first support member 60A is formed so as to cover a level-difference portion formed between the first terminal portion 50ig and the second terminal portion 50ih.

### (Second Support Member)

The second support member 60B is disposed at a position apart from the side surface 70c of the resin mold 70 and extends in a direction in which the plurality of the power terminals 50c and 50e are arrayed. That is, the second support member 60B extends in a direction substantially perpendicularly crossing to a direction in which each of the plurality of the power terminals 50c and 50e extends. The second support member 60B covers part of the outer-periphery of each of the plurality of the power terminals 50c and 50e, and fixes the plurality of the power terminals 50c and 50e such that the plurality of the power terminals 50c and 50e are spaced from each other. In other words, the second support member 60B bundles the plurality of the power terminals 50c and 50e and maintains the distance between the power terminals 50c and 50e.

The power terminal 50c has an end portion 50ce located on the opposite side of the side surface 70c of the resin mold 70. The power terminal 50e has an end portion 50ee located on the opposite side of the side surface 70c of the resin mold 70. The second support member 60B is disposed closer to the end portions 50ce and 50ee than the side surface 70c of the resin mold 70.

The power terminal 50c has a bent portion 50cf located between the side surface 70c of the resin mold 70 and the second support member 60B.

The power terminal 50e has a bent portion 50ef located between the side surface 70c of the resin mold 70 and the second support member 60B.

As shown in FIG. 4B, the power terminal 50c has: a first terminal portion 50cg protruding from the side surface 70c of the resin mold 70; and a second terminal portion 50ch having the end portion 50ce. The second terminal portion 50ch is continuous to the first terminal portion 50cg. The second terminal portion 50ch has a width smaller than the width of the first terminal portion 50cg in the direction in which the power terminals 50c and 50e are arrayed.

The power terminal 50e has: a first terminal portion 50eg protruding from the side surface 70c of the resin mold 70; and a second terminal portion 50eh having the end portion 50ee. The second terminal portion 50eh is continuous to the first terminal portion 50eg. The second terminal portion 50eh has a width smaller than the width of the first terminal portion 50eg in the direction in which the power terminals 50c and 50e are arrayed.

Note that, although the power terminal 50d is not shown in FIG. 4B, the same configuration as those of the power terminals 50c and 50e may be applied to the power terminal 50d.

In this case, the power terminal 50d has: a first terminal portion 50dg protruding from the side surface 70c of the resin mold 70; and a second terminal portion 50dh having an end portion 50de. The second terminal portion 50dh is continuous to the first terminal portion 50dg. The second terminal portion 50dh has a width smaller than the width of the first terminal portion 50dg in a direction in which the plurality of the power terminals are arrayed.

The second support member 60B covers part of the outer-periphery of the second terminal portions 50ch and 50eh, and fixes the second terminal portions 50ch and 50eh. The second support member 60B is disposed at a boundary between the first terminal portion 50cg and the second terminal portion 50ch and is disposed at a boundary between the first terminal portion 50eg and the second terminal portion 50eh. In other words, the second support member 60B is formed so as to cover a level-difference portion formed between the first terminal portion 50eg and the second terminal portion 50eh and a level-difference portion formed between the first terminal portion 50cg and the second terminal portion 50ch.

Each of the shapes of the first support member 60A and the second support member 60B is, for example, a rectangular parallelepiped shape. Here, the rectangular parallelepiped shape is a shape having a long side extending in the direction of the side of the resin mold 70. Each of the first support member 60A and the second support member 60B is disposed parallel to the side surface 70c of the resin mold 70.

As shown in FIG. 4C, in the thickness direction TH of the first support member 60A, a center position P1 of the first support member 60A coincides with a center position P2 of the control terminal 50i. Moreover, the thickness of the first support member 60A is greater than or equal to the thickness of the control terminal 50i. That is, the thickness of the first support member 60A and the thickness of the control terminal 50i are determined such that the structure of the first support member 60A and the structure of the control terminal 50i are symmetrical with respect to the center line C passing through the center positions P1 and P2.

Similarly, also in the thickness direction of the second support member 60B, the center position of the second support member 60B coincides with the center position of each of the power terminals 50c and 50e. Additionally, the thickness of the second support member 60B is greater than or equal to the thickness of each of the power terminals 50c and 50e. That is, the power terminals 50c and 50e is fixed by the second support member 60B such that the second support member 60B and the power terminals 50c and 50e are symmetrical with respect to the center line C passing through the center positions P1 and P2.

Each of the plurality of the control terminals 50i has two first surfaces F and two second surfaces S. The first surface F is a surface parallel to the direction (reference numeral D3 shown in FIG. 3) orthogonal to the direction in which the control terminal 50i extends (reference numeral D1 shown in FIG. 3) and the direction in which the control terminals 50i are arrayed (reference numeral D2 shown in FIG. 3). The second surface S is a surface parallel to the direction in which the control terminals 50i are arrayed (reference numeral D2 shown in FIG. 3). The first support member 60A covers the two first surfaces F and the two second surfaces S of each of the plurality of the control terminals 50i.

Similarly, each of the power terminals 50c and 50e has two first surfaces F and two second surfaces S. The first surface F is a surface parallel to the direction (reference numeral E3 shown in FIG. 3) orthogonal to the direction in which the power terminals 50c and 50e extend (reference numeral E1 shown in FIG. 3) and the direction in which the power terminals 50c and 50e are arrayed (reference numeral E2 shown in FIG. 3). The second surface S is a surface parallel to the direction in which the power terminals 50c and 50e are arrayed (reference numeral E2 shown in FIG. 3). The second support member 60B covers the two first surfaces F and the two second surfaces S of each of the power terminals 50c and 50e.

Note that, the thickness of the support member 60 is less than or equal to the thickness of the resin mold 70.

This is because, the support member 60 only fixes the control terminals 50i and the power terminals 50c and 50e, and a pressure applied to the support member 60 is low, as compared to the resin mold 70 covering the plurality of the semiconductor switching elements, the terminal members, and the connection wirings.

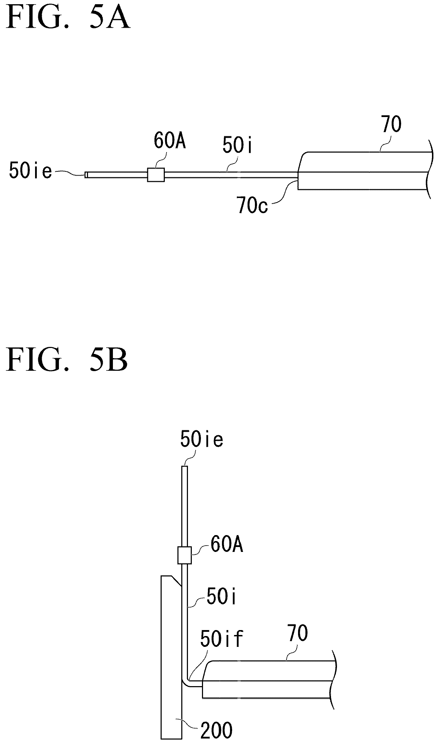

Next, a step of forming a bent portion by bending an outer terminal will be described with reference to FIGS. 5A and 5B.

FIGS. 5A and 5B are enlarged cross-sectional views showing a relevant part of the semiconductor module 60a and are views showing a step of bending the outer terminal.

In the following explanation, a step of bending the control terminal 50i will be described. Since a step of bending the power terminals 50c and 50e is the same as the step of bending the control terminal 50i, the explanation therefor is omitted.

First of all, as shown in FIG. 5A, the first support member 60A is formed at the plurality of the control terminals 50i. The position at which the first support member 60A is formed is a position closer to the end portion 50ie than the side surface 70c of the resin mold 70. Consequently, the plurality of the control terminals 50i is bundled together by the first support member 60A.

Next, a jig 200 is disposed under the control terminal 50i, and the jig 200 moves upward from the lower side. The jig 200 comes into contact with the control terminal 50i. Furthermore, the jig 200 bends the control terminal 50i in accordance with the upward movement of the jig 200. Therefore, the bent portion 50if is formed at the control terminal 50i between the side surface 70c of the resin mold 70 and the first support member 60A.

According to the semiconductor module 60a of the first embodiment, the plurality of the control terminals 50i can be bundled together by the first support member 60A. The plurality of the power terminals 50c and 50e can be bundled together by the second support member 60B. Consequently, deformation of the terminal member 50 is suppressed when working the terminal member 50, and it is possible to stabilize the size of each of the plurality of the control terminals 50i and the plurality of the power terminals 50c and 50e after machining.

Furthermore, since each of the first support member 60A and the second support member 60B has the rectangular parallelepiped shape, the shape of each of the first support member 60A and the second support member 60B can be the minimum size. Consequently, the shape of the semiconductor module 60a attached to each of the first support member 60A and the second support member 60B can be downsized.

Additionally, the center position of the support member 60 (the first support member 60A and the second support member 60B) coincides with the center positions of the outer terminals (the control terminals 50i and the power terminals 50c and 50e) in the thickness direction TH. For this reason, deformation of the support member 60 such as warpage, torsion, or the like is suppressed, and it is possible to stabilize accuracy of dimensions of the control terminals 50i and the power terminals 50c and 50e.

Moreover, since the outer terminals (the control terminals 50i and the power terminals 50c and 50e) are fixed by the support member 60, a stress applied to the outer terminals can be absorbed by the support member 60 when cutting the outer terminals in the step of manufacturing the semiconductor module 60a. Accordingly, the resin forming the resin mold 70 is suppressed from being peeled off from the outer terminals in the step of forming the resin mold 70 and the outer terminals. Moreover, due to provision of the support member 60, deformation of the outer terminal such as torsion, twist, or the like can be suppressed in the step of forming the outer terminals.

Furthermore, the first support member 60A is disposed closer to the end portion 50ie than the side surface 70c of the resin mold 70 in the first embodiment. In addition, the second support member 60B is disposed closer to the end portions 50ce and 50ee than the side surface 70c of the resin mold 70. Consequently, even in a case in which the positions of the outer terminals (the control terminals 50i and the power terminals 50c and 50e) are displaced in the step of forming the semiconductor module 60a, an effect of restoring the positions of the outer terminals to original positions by the support member 60 (the first support member 60A and the second support member 60B), that is, an effect of rectifying the positions of the outer terminals can be obtained.

The support member 60 (the first support member 60A and the second support member 60B) extends in a direction in which the plurality of the outer terminals (the control terminals 50i and the power terminals 50c and 50e) are arrayed. Additionally, the support member 60 is not formed at a portion at which the outer terminal is not formed. Therefore, the length of the support member 60 can be shorter, and it contributes to downsizing of the semiconductor module 60a.

Since the first support member 60A covers the two first surfaces F and the two second surfaces S of each of the plurality of the control terminals 50i, it is possible to suppress deformation of the plurality of the control terminals 50i in the direction parallel to each of the first surface F and the second surface S.

Similarly, the second support member 60B covers the two first surfaces F and the two second surfaces S of each of the power terminals 50c and 50e, it is possible to suppress deformation of the power terminals 50c and 50e in the direction parallel to each of the first surface F and the second surface S.

Furthermore, as shown in FIGS. 5A and 5B, since the first support member 60A is disposed closer to the end portion 50ie than the side surface 70c of the resin mold 70, it is possible to avoid interference such that the jig 200 comes into contact with the first support member 60A even in a case of forming the bent portion 50if by using the jig 200.

### First Modified Example of First Embodiment

In the modified example 1, the material of the support member 60 (the first support member 60A and the second support member 60B) is the same as the material of the resin mold 70.

Consequently, when forming the resin mold 70, the support member 60 can be formed by using the same material as that of the resin mold 70. That is, the resin mold 70 and the support member 60 can be formed in the same step. Therefore, it is not necessary to form the support member 60 in the step different from the step of forming the resin mold 70. Accordingly, it is possible to omit a step of forming only the support member 60.

### Second Modified Example of First Embodiment

The modified example 2 is different from the first embodiment in that the resin mold 70 has a rectangular shape.

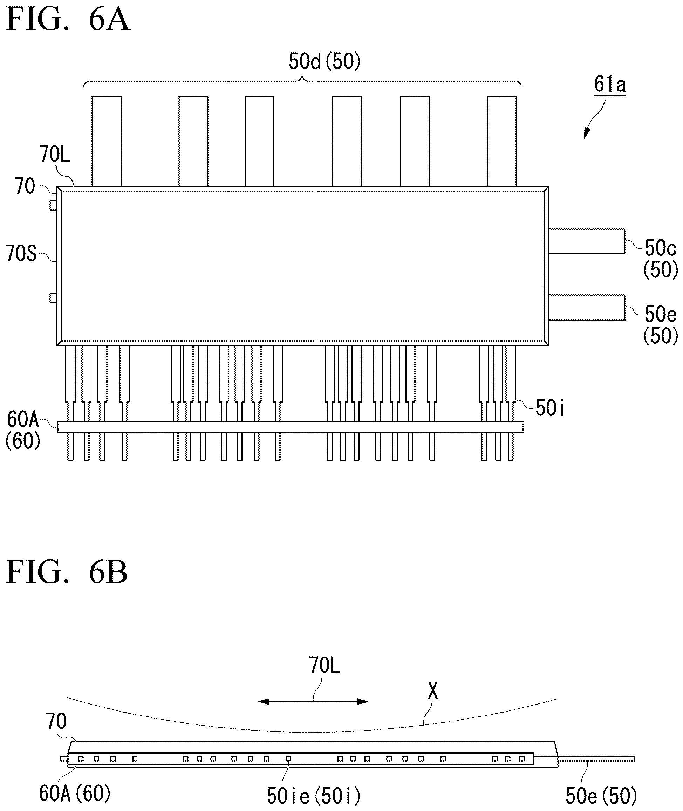

FIG. 6A is a plan view showing a semiconductor module 61a. FIG. 6B is a side view showing the semiconductor module 61a. Furthermore, reference letter X shown in FIG. 6B schematically shows a case in which warpage occurs on the resin mold 70 during molding the resin mold 70.

Note that, in FIG. 6A, the second support member 60B is omitted.

As shown in FIG. 6A, the resin mold 70 having the rectangular shape has a long side 70L and a short side 70S when viewed in a plan view.

The first support member 60A (60) extends along the long side 70L and fixes the plurality of the control terminals 50i and bundles them together.

Warpage may occur on the resin mold 70 during molding the resin mold 70. The warpage is likely to occur in the direction of the long side 70L of the resin mold 70 as shown by reference letter X. When the foregoing warpage occurs on the resin mold 70, the positions of the end portions 50ie of the control terminals 50i may be displaced.

In contrast, as shown in FIG. 6B, since the first support member 60A is provided in the modified example 2, such warpage is suppressed from occurring on the resin mold 70 by the first support member 60A even in the case in which the resin mold 70 has the rectangular shape.

### Second Embodiment

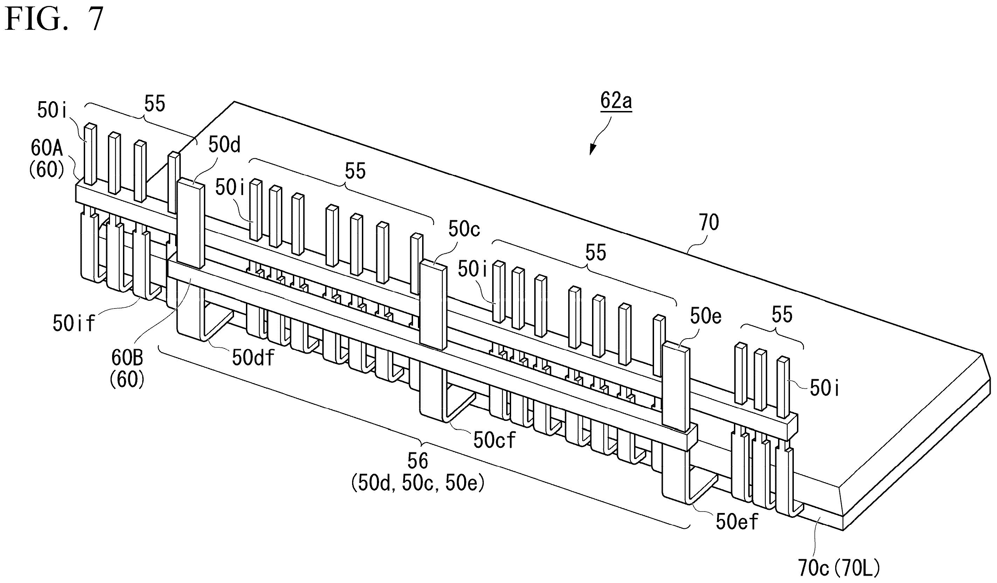

FIG. 7 is a perspective view showing a semiconductor module 62a according to the second embodiment.

The second embodiment is different from the aforementioned first embodiment in that the resin mold 70 has the rectangular shape and a plurality of outer terminals are arrayed in two rows.

As shown in FIG. 7, the semiconductor module 62a includes the resin mold 70 having the rectangular shape, the plurality of the control terminals 50i, and the power terminals 50c, 50d, and 50e. The plurality of the control terminals 50i and the power terminals 50c, 50d, and 50e are drawn out from one long side 70L constituting the resin mold 70.

The plurality of the control terminals 50i (first outer terminal) constitute a first terminal group 55 including a plurality of outer terminals arranged in a first row. Each of the plurality of the control terminals 50i has the bent portion 50if (first bent portion) located between the side surface 70c of the resin mold 70 and the first support member 60A. The first support member 60A fixes the plurality of the control terminals 50i and bundles them together such that the plurality of the control terminals 50i constituting the first terminal group 55 are spaced from each other.

The power terminals 50c, 50d, and 50e (second outer terminal) constitute a second terminal group 56 including a plurality of outer terminals arranged in a second row. The power terminals 50c, 50d, and 50e have the bent portions 50cf, 50df, and 50ef

(second bent portion), respectively, which are located between the side surface 70c of the resin mold 70 and the second support member 60B. The second support member 60B fixes the power terminals 50c, 50d, and 50e and bundles them together such that the power terminals 50c, 50d, and 50e constituting the second terminal group 56 are spaced from each other.

As shown in FIG. 4B, the second support member 60B is formed so as to cover the level-difference portion formed between the first terminal portion 50eg and the second terminal portion 50eh and the level-difference portion formed between the first terminal portion 50cg and the second terminal portion 50ch. Consequently, the second support member 60B is caught and fixed by the level-difference portion.

The distances from the side surface 70c of the resin mold 70 to the bent portions 50cf, 50df, and 50ef are greater than the distance from the side surface 70c of the resin mold 70 to the bent portion 50if. Additionally, the first support member 60A and the second support member 60B are parallel to each other.

According to the semiconductor module 62a of the second embodiment, the plurality of the control terminals 50i can be fixed and bundled together by the first support member 60A. The plurality of the power terminals 50c, 50d, and 50e can be fixed and bundled together by the second support member 60B. Consequently, deformation of the terminal member 50 is suppressed when working the terminal member 50, and it is possible to stabilize the size of each of the plurality of the control terminals 50i and the plurality of the power terminals 50c, 50d, and 50e after machining. Furthermore, it is possible to obtain the effect the same as or similar to that of the above-mentioned first embodiment.

### Modified Example of Second Embodiment

Note that, as shown in FIG. 7, in a case in which the plurality of the bent portions are arrayed in two rows, a support member may be provided so as to correspond to the positions of the bent portions 50cf, 50df, and 50ef. With this configuration, even the case in which the plurality of the bent portions are arrayed, it is possible to rectify the positions of the bent portions of the plurality of the power terminals 50c, 50d, and 50e by the support member.

### Third embodiment

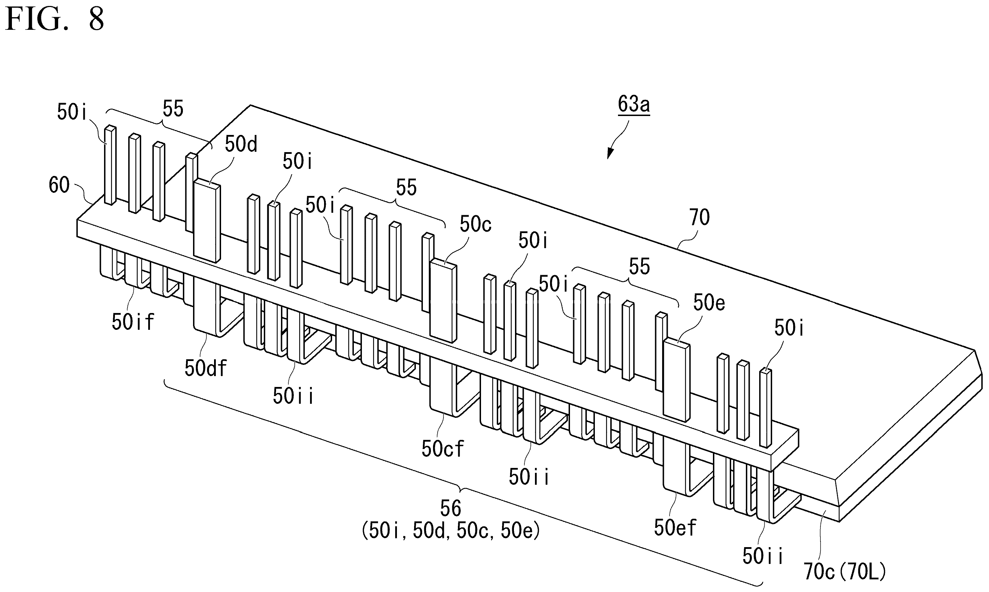

FIG. 8 is a perspective view showing a semiconductor module according to a third embodiment.

The third embodiment is different from the aforementioned second embodiment in that the plurality of the outer terminals arrayed in two rows are fixed by one support member 60.

As shown in FIG. 8, a semiconductor module 63a includes the resin mold 70 having the rectangular shape, the plurality of the control terminals 50i, and the power terminals 50c, 50d, and 50e. The plurality of the control terminals 50i and the power terminals 50c, 50d, and 50e are drawn out from one long side 70L constituting the resin mold 70.

The plurality of the control terminals 50i (first outer terminal) constitute the first terminal group 55 including a plurality of outer terminals arranged in the first row. Each of the plurality of the control terminals 50i has the bent portion 50if (first bent portion) located between the side surface 70c of the resin mold 70 and the support member 60.

The power terminals 50c, 50d, and 50e (second outer terminal) and the plurality of the control terminals 50i (second outer terminal) constitute the second terminal group 56 including a plurality of outer terminals arranged in the second row. The power terminals 50c, 50d, and 50e have the bent portions 50cf, 50df, and 50ef (second bent portion), respectively, which are located between the side surface 70c of the resin mold 70 and the support member 60. Furthermore, each of the plurality of the control terminals 50i arranged in the second row has a bent portion 50ii (second bent portion) located between the side surface 70c of the resin mold 70 and the support member 60.

The distances from the side surface 70c of the resin mold 70 to the bent portions 50cf, 50df, 50ef, and 50ii are greater than the distance from the side surface 70c of the resin mold 70 to the bent portion 50if.

The support member 60 fixes the plurality of the control terminals 50i constituting the first terminal group 55, the power terminals 50c, 50d, and 50e constituting the second terminal group 56, and the plurality of the control terminals 50i and bundles them together such that they are spaced from each other.

According to the semiconductor module 63a of the third embodiment, the plurality of the control terminals 50i and the plurality of the power terminals 50c, 50d, and 50e can be fixed and bundled together by one support member 60A. Consequently, deformation of the terminal member 50 is suppressed when working the terminal member 50, and it is possible to stabilize the size of each of the plurality of the control terminals 50i and the plurality of the power terminals 50c, 50d, and 50e after machining. Furthermore, it is possible to obtain the effect the same as or similar to that of the above-mentioned first embodiment.

Furthermore, since the number of the support members 60 is one, the number of support members can be reduced. Since the plurality of the control terminals 50i and the plurality of the power terminals 50c, 50d, and 50e can be collectively bundled together, it is possible to improve accuracy of the dimensions thereof.

The invention is defined by the appended claims.

### [Reference Symbol Explanation]

1...control unit, 2...motor, 3...control circuit, 4...inverter circuit, 5...power relay, 5a, 5b...switching element, 6...first sensor, 7U, 7V, 7W...capacitor, 8...second sensor, 9...battery, 10...ignition switch, 31...drive circuit, 32...input circuit, 33...power supply circuit, 41U...high-potential-side switching element (semiconductor switching element), 42U...low-potential-side switching element (semiconductor switching element), 43U...shunt resistance, 44U...relay switching element (semiconductor switching element), 45a, 45b, 46a, 46b, 46c, 46d...connection wiring, 50 ... terminal member, 50a, 50b, 50f, 50g, 50h...inner terminal, 50c, 50d, 50e...power terminal, 50ce, 50de, 50ee, 50ie...end portion, 50cf, 50df, 50ef, 50if, 50ii...bent portion, 50cg, 50dg, 50eg...first terminal portion, 50dh, 50ch, 50eh...second terminal portion, 50i...control terminal, 50ia...first control terminal (control terminal), 50ib...second control terminal (control terminal), 50ic...third control terminal (control terminal), 50id...fourth control terminal (control terminal), 50ig...first terminal portion, 50ih...second terminal portion, 50j, 50k...inner terminal, 55...first terminal group, 56...second terminal group, 60...support member, 60a, 61a, 62a, 63a...semiconductor module, 60A...first support member (support member), 60B...second support member (support member), 70...resin mold, 70a...outer-periphery, 70b...region, 70c...side surface, 70L...long side, 70S...short side, 100...vehicle electric power steering device, 200...jig, F...first surface, S...second surface, P1...center position, P2...center position, TM...terminal group

## Claims

1. A semiconductor module (60a, 61a, 62a, 63a) comprising:
a plurality of semiconductor switching elements (41U);
a resin mold (70) having a side surface (70c) and surrounding the plurality of the semiconductor switching elements (41U);
a terminal member (50) having
a plurality of inner terminals (50a, 50b, 50f, 50g, 50h) electrically connected to the plurality of the semiconductor switching elements (41U) inside the resin mold (70), and
a plurality of outer terminals (50c, 50d, 50e, 50i) protruding from the side surface (70c) of the resin mold (70); and
a support member (60, 60A, 60B) disposed at a position apart from the side surface (70c) of the resin mold (70), the support member (60, 60A, 60B) extending in a direction in which the plurality of the outer terminals (50c, 50d, 50e, 50i) are arrayed, the support member (60, 60A, 60B) covering a part of an outer-periphery of each of the plurality of the outer terminals (50c, 50d, 50e, 50i), the support member (60, 60A, 60B) fixing the plurality of the outer terminals (50c, 50d, 50e, 50i) such that the plurality of the outer terminals (50c, 50d, 50e, 50i) are spaced from each other,
wherein
each of the plurality of the outer terminals (50c, 50d, 50e, 50i) has
a first terminal portion (50cg, 50dg, 50eg, 50ig) protruding from the side surface (70c) of the resin mold (70),
a second terminal portion (50ch, 50dh, 50eh, 50ih) having an end portion,
**characterised by**
the end portion having a width smaller than a width of the first terminal portion (50cg, 50dg, 50eg, 50ig) in a direction in which the plurality of the outer terminals (50c, 50d, 50e, 50i) are arrayed, the end portion being continuous to the first terminal portion (50cg, 50dg, 50eg, 50ig), the end portion being located on an opposite side of the side surface (70c) of the resin mold (70), and
a level-difference portion formed between the first terminal portion (50cg, 50dg, 50eg, 50ig) and the second terminal portion (50ch, 50dh, 50eh, 50ih), and wherein
the support member (60, 60A, 60B) is located at a boundary between the first terminal portion (50cg, 50dg, 50eg, 50ig) and the second terminal portion (50ch, 50dh, 50eh, 50ih), and covers the level-difference portion.

2. The semiconductor module (60a, 61a, 62a, 63a) according to claim 1, wherein
a material of the resin mold (70) is a same as a material of the support member (60, 60A, 60B).

3. The semiconductor module (60a, 61a, 62a, 63a) according to claim 1 or claim 2, wherein
a shape of the support member (60, 60A, 60B) is a rectangular parallelepiped shape, and
the support member (60, 60A, 60B) is disposed parallel to the side surface (70c) of the resin mold (70).

4. The semiconductor module (60a, 61a, 62a, 63a) according to any one of claims 1 to 3, wherein
a center position (P1) of the support member (60, 60A, 60B) coincides with a center position (P2) of each of the plurality of the outer terminals (50c, 50d, 50e, 50i) in a thickness direction of the support member (60, 60A, 60B).

5. The semiconductor module (60a, 61a, 62a, 63a) according to any one of claims 1 to 4, wherein
each of the plurality of the outer terminals (50c, 50d, 50e, 50i) has an end portion (50ie) located on an opposite side of the side surface (70c) of the resin mold (70), and
the support member (60, 60A, 60B) is disposed closer to the end portion (50ie) than the side surface (70c) of the resin mold (70).

6. The semiconductor module (60a, 61a, 62a, 63a) according to any one of claims 1 to 5, wherein
a thickness of the support member (60, 60A, 60B) is less than or equal to a thickness of the resin mold (70).

7. The semiconductor module (60a, 61a, 62a, 63a) according to any one of claims 1 to 6, wherein
each of the plurality of the outer terminals (50c, 50d, 50e, 50i) has
two first surfaces (F) parallel to a direction orthogonal to a direction in which the plurality of the outer terminals (50c, 50d, 50e, 50i) extend and a direction in which the plurality of the outer terminals (50c, 50d, 50e, 50i) are arrayed, and
two second surfaces (S) parallel to a direction in which the plurality of the outer terminals (50c, 50d, 50e, 50i) are arrayed, and wherein
the support member (60, 60A, 60B) covers the two first surfaces (F) and the two second surfaces (S).

8. The semiconductor module (60a, 61a, 62a, 63a) according to any one of claims 1 to 7, wherein
Each of the plurality of the outer terminals (50c, 50d, 50e, 50i) has a bent portion (50cf, 50ef, 50if) located between the side surface (70c) of the resin mold (70) and the support member (60, 60A, 60B).

9. The semiconductor module (60a, 61a, 62a, 63a) according to any one of claims 1 to 8, wherein
the plurality of the outer terminals (50c, 50d, 50e, 50i) include a first terminal group (55) and a second terminal group (56), the first terminal group (55) including a plurality of first outer terminals (50i) having a first bent portion (50if) located between the side surface (70c) of the resin mold (70) and the support member (60, 60A, 60B), the second terminal group (56) including a plurality of second outer terminals (50c, 50d, 50e, 50i) having a second bent portion (50cf, 50df, 50ef, 50ii) located between the side surface (70c) of the resin mold (70) and the support member (60, 60A, 60B),
a distance from the side surface (70c) of the resin mold (70) to the second bent portion (50ef) is greater than a distance from the side surface (70c) of the resin mold (70) to the first bent portion (50if),
the support member (60, 60A, 60B) includes a first support member (60A) and a second support member (60B) parallel to each other,
the first support member (60A) fixes the plurality of the first outer terminals (50i) such that the plurality of the first outer terminals (50i) of the first terminal group (55) are spaced apart from each other, and
the second support member (60B) fixes the plurality of the second outer terminals (50c, 50d, 50e, 50i) such that the plurality of the second outer terminals (50c, 50d, 50e, 50i) of the second terminal group (56) are spaced apart from each other.

10. The semiconductor module (60a, 61a, 62a, 63a) according to any one of claims 1 to 8, wherein
the plurality of the outer terminals (50c, 50d, 50e, 50i) include a first terminal group (55) and a second terminal group (56), the first terminal group (55) including a plurality of first outer terminals (50i) having a first bent portion (50if) located between the side surface (70c) of the resin mold (70) and the support member (60, 60A, 60B), the second terminal group (56) including a plurality of second outer terminals (50c, 50d, 50e, 50i) having a second bent portion (50ef) located between the side surface (70c) of the resin mold (70) and the support member (60, 60A, 60B),
a distance from the side surface (70c) of the resin mold (70) to the second bent portion () is greater than a distance from the side surface (70c) of the resin mold (70) to the first bent portion (50if),
the support member (60, 60A, 60B) fixes: the plurality of the first outer terminals (50i) such that the plurality of the first outer terminals (50i) of the first terminal group (55) are spaced apart from each other; and the plurality of the second outer terminals (50c, 50d, 50e, 50i) such that the plurality of the second outer terminals (50c, 50d, 50e, 50i) of the second terminal group (56) are spaced apart from each other.

## Patentansprüche

1. Halbleitermodul (60a, 61a, 62a, 63a) umfassend:
eine Vielzahl von Halbleiterschaltelementen (41U);
eine Harzform (70), die eine Seitenfläche (70c) aufweist und die Vielzahl der Halbleiterschaltelemente (41U) umgibt;
ein Anschlusselement (50) aufweisend
eine Vielzahl innerer Anschlüsse (50a, 50b, 50f, 50g, 50h), die elektrisch mit der Vielzahl der Halbleiterschaltelemente (41U) innerhalb der Harzform (70) verbunden sind, und
eine Vielzahl äußerer Anschlüsse (50c, 50d, 50e, 50i), die aus der Seitenfläche (70c) der Harzform (70) herausragen; und
ein Stützelement (60, 60A, 60B), das an einer von der Seitenfläche (70c) der Harzform (70) beabstandeten Position angeordnet ist, wobei sich das Stützelement (60, 60A, 60B) sich in einer Richtung erstreckt, in der die Vielzahl der äußeren Anschlüsse (50c, 50d, 50e, 50i) geordnet sind, wobei das Stützelement (60, 60A, 60B) einen Teil einer Außenumgebung jedes der Vielzahl der äußeren Anschlüsse (50c, 50d, 50e, 50i) abdeckt, wobei die Stützung (60, 60A, 60B) die Vielzahl der äußeren Anschlüsse (50c, 50d, 50e, 50i) fixiert, sodass die Vielzahl der äußeren Anschlüsse (50c, 50d, 50e, 50i) voneinander beabstandet sind, wobei
jeder der Vielzahl der äußeren Anschlüsse (50c, 50d, 50e, 50i)
einen ersten Anschlussabschnitt (50cg, 50dg, 50eg, 50ig) aufweist, der von der Seitenfläche (70c) der Harzform (70) vorsteht,
einen zweiten Anschlussabschnitt (50ch, 50dh, 50eh, 50ih) aufweist, der einen Endabschnitt aufweist,
**dadurch gekennzeichnet, dass** der Endabschnitt eine Breite aufweist, die kleiner ist als eine Breite des ersten Anschlussabschnitts (50cg, 50dg, 50eg, 50ig) in einer Richtung, in der die Vielzahl der äußeren Anschlüsse (50c, 50d, 50e, 50i) geordnet sind, wobei der Endabschnitt mit dem ersten Anschlussabschnitt (50cg, 50dg, 50eg, 50ig) kontinuierlich ist, wobei der Endabschnitt auf einer entgegengesetzten Seite der Seitenfläche (70c) der Harzform (70) angeordnet ist, und
ein Levelunterschiedsabschnitt zwischen dem ersten Abschnitt (50cg, 50dg, 50eg, 50ig) und dem zweiten Abschnitt (50ch, 50dh, 50eh, 50ih) gebildet ist, und wobei
das Stützelement (60, 60A, 60B) an einer Begrenzung zwischen dem ersten Anschlussabschnitt (50cg, 50dg, 50eg, 50ig) und dem zweiten Anschlussabschnitt (50ch, 50dh, 50eh, 50ih) angeordnet ist und die Abdeckung des Levelunterschiedsabschnitts übernimmt.

2. Halbleitermodul (60a, 61a, 62a, 63a) gemäß Anspruch 1, wobei
ein Material der Harzform (70) dasselbe ist wie ein Material des Stützelements (60, 60A, 60B).

3. Halbleitermodul (60a, 61a, 62a, 63a) gemäß Anspruch 1 oder Anspruch 2, wobei
die Form des Stützelements (60, 60A, 60B) eine rechteckige Parallelepipedform ist, und
das Stützelement (60, 60A, 60B) parallel zur Seitenfläche (70c) der Harzform (70) angeordnet ist.

4. Halbleitermodul (60a, 61a, 62a, 63a) gemäß einem der Ansprüche 1 bis 3, wobei
eine Mittenposition (P1) des Stützelements (60, 60A, 60B) mit einer Mittenposition (P2) jedes der Vielzahl der äußeren Anschlüsse (50c, 50d, 50e, 50i) in einer Dickenrichtung des Stützelements (60, 60A, 60B) übereinstimmt.

5. Halbleitermodul (60a, 61a, 62a, 63a) gemäß einem der Ansprüche 1 bis 4, wobei
jeder der Vielzahl der äußeren Anschlüsse (50c, 50d, 50e, 50i) einen Endabschnitt (50ie) aufweist, der sich auf einer entgegengesetzten Seite der Seitenfläche (70c) der Harzform (70) befindet, und
das Stützelement (60, 60A, 60B) näher am Endabschnitt (50ie) als an der Seitenfläche (70c) der Harzform (70) angeordnet ist.

6. Halbleitermodul (60a, 61a, 62a, 63a) gemäß einem der Ansprüche 1 bis 5, wobei
die Dicke des Stützelements (60, 60A, 60B) kleiner oder gleich der Dicke der Harzform (70) ist.

7. Halbleitermodul (60a, 61a, 62a, 63a) nach einem der Ansprüche 1 bis 6, wobei
jeder der Vielzahl der äußeren Anschlüsse (50c, 50d, 50e, 50i) aufweist
zwei erste Oberflächen (F), die parallel zu einer Richtung sind, die orthogonal zu einer Richtung ist, in der sich die Vielzahl der äußeren Anschlüsse (50c, 50d, 50e, 50i) erstrecken, und einer Richtung, die parallel zu einer Richtung ist, in der die Vielzahl der äußeren Anschlüsse (50c, 50d, 50e, 50i) geordnet sind, und
zwei zweite Oberflächen (S), die parallel zu einer Richtung sind, in der die Vielzahl der äußeren Anschlüsse (50c, 50d, 50e, 50i) geordnet sind, und wobei
das Stützelement (60, 60A, 60B) die beiden ersten Oberflächen (F) und die beiden zweiten Oberflächen (S) abdeckt.

8. Halbleitermodul (60a, 61a, 62a, 63a) gemäß einem der Ansprüche 1 bis 7, wobei
jeder der Vielzahl der äußeren Anschlüsse (50c, 50d, 50e, 50i) einen gebogenen Abschnitt (50cf, 50ef, 50if) aufweist, der sich zwischen der Seitenfläche (70c) der Harzform (70) und dem Stützelement (60, 60A, 60B) befindet.

9. Halbleitermodul (60a, 61a, 62a, 63a) gemäß einem der Ansprüche 1 bis 8, wobei
die Vielzahl der äußeren Anschlüsse (50c, 50d, 50e, 50i) eine erste Anschlussgruppe (55) und eine zweite Anschlussgruppe (56) umfassen, wobei die erste Anschlussgruppe (55) eine Vielzahl erster äußerer Anschlüsse (50i) umfasst, die einen ersten gebogenen Abschnitt (50if) aufweist, der sich zwischen der Seitenfläche (70c) der Harzform (70) und dem Stützelement (60, 60A, 60B) befindet, wobei die zweite Anschlussgruppe (56) eine Vielzahl zweiter äußerer Anschlüsse (50c, 50d, 50e, 50i) mit einem zweiten gebogenen Abschnitt (50cf, 50df, 50ef, 50ii) aufweist, der sich zwischen der Seitenfläche (70c) der Harzform (70) und dem Stützelement (60, 60A, 60B) umfasst, wobei
der Abstand von der Oberfläche (70c) der Harzform (70) zum zweiten gebogenen Abschnitt (50ef) größer ist als der Abstand von der Oberfläche (70c) der Harzform (70) zum ersten gebogenen Abschnitt (50if),
das Stützelement (60, 60A, 60B) ein erstes Stützungselement (60A) und ein zweites Stützungselement (60B) umfasst, die parallel zueinander sind,
das erste Stützungselement (60A) die Vielzahl der ersten äußeren Anschlüsse (50i) so fixiert, dass die Vielzahl der ersten äußeren Anschlüsse (50i) der ersten Anschlussgruppe (55) voneinander beabstandet sind, und
das zweite Stützungselement (60B) die Vielzahl der zweiten äußeren Anschlüsse (50c, 50d, 50e, 50i) so fixiert, dass die Vielzahl der zweiten äußeren Anschlüsse (50c, 50d, 50e, 50i) der zweiten Anschlussgruppe (56) voneinander beabstandet sind.

10. Halbleitermodul (60a, 61a, 62a, 63a) gemäß einem der Ansprüche 1 bis 8, wobei
die Vielzahl der äußeren Anschlüsse (50c, 50d, 50e, 50i) eine erste Anschlussgruppe (55) und eine zweite Anschlussgruppe (56) umfasst, wobei die erste Anschlussgruppe (55) eine Vielzahl erster äußerer Anschlüsse (50i) mit einem ersten gebogenen Abschnitt (50if) aufweist, die zwischen der Seitenfläche (70c) der Harzform (70) und dem Stützelement (60, 60A, 60B) angeordnet ist, wobei die zweite Anschlussgruppe (56) eine Vielzahl zweiter äußerer Anschlüsse (50c, 50d, 50e, 50i) mit einem zweiten gebogenen Abschnitt (50ef) umfasst, der zwischen der Seitenfläche (70c) der Harzform (70) und dem Stützelement (60, 60A, 60B) angeordnet ist,
der Abstand von der Seitenfläche (70c) der Harzform (70) zum zweiten gebogenen Abschnitt () größer ist als der Abstand von der Seitenfläche (70c) der Harzform (70) zum ersten gebogenen Abschnitt (50if),
das Stützungselement (60, 60A, 60B) fixiert: die Vielzahl der ersten äußeren Anschlüsse (50i), sodass die Vielzahl der ersten äußeren Anschlüsse (50i) der ersten Anschlussgruppe (55) voneinander beabstandet sind; und die Vielzahl der zweiten äußeren Anschlüsse (50c, 50d, 50e, 50i), sodass die Vielzahl der zweiten äußeren Anschlüsse (50c, 50d, 50e, 50i) der zweiten Anschlussgruppe (56) voneinander beabstandet sind.

## Revendications

1. Module semi-conducteur (60a, 61a, 62a, 63a) comprenant :
une pluralité d'éléments de commutation semi-conducteurs (41U) ;
un moule en résine (70) ayant une surface latérale (70c) et entourant la pluralité d'éléments de commutation semi-conducteurs (41U) ;
un élément terminal (50) comportant
une pluralité de bornes internes (50a, 50b, 50f, 50g, 50h) connectées électriquement à la pluralité d'éléments de commutation semi-conducteurs (41U) à l'intérieur du moule en résine (70), et
une pluralité de bornes externes (50c, 50d, 50e, 50i) faisant saillie à partir de la surface latérale (70c) du moule en résine (70) ; et
un élément de support (60, 60A, 60B) disposé à une position éloignée de la surface latérale (70c) du moule en résine (70), l'élément de support (60, 60A, 60B) s'étendant dans une direction dans laquelle la pluralité de bornes externes (50c, 50d, 50e, 50i) sont disposées, l'élément de support (60, 60A, 60B) recouvrant une partie d'une périphérie extérieure de chacune de la pluralité des bornes externes (50c, 50d, 50e, 50i), l'élément de support (60, 60A, 60B) fixant la pluralité de bornes externes (50c, 50d, 50e, 50i) de telle sorte que la pluralité de bornes externes (50c, 50d, 50e, 50i) soient espacées les unes des autres,
dans lequel
chacune de la pluralité des bornes externes (50c, 50d, 50e, 50i) comporte
une première partie de borne (50cg, 50dg, 50eg, 50ig) faisant saillie à partir de la surface latérale (70c) du moule en résine (70),
une deuxième partie de borne (50ch, 50dh, 50eh, 50ih) ayant une partie d'extrémité,
**caractérisé en ce que**
la partie d'extrémité ayant une largeur inférieure à la largeur de la première partie de borne (50cg, 50dg, 50eg, 50ig) dans une direction dans laquelle la pluralité de bornes externes (50c, 50d, 50e, 50i) sont disposées, la partie d'extrémité étant continue avec la première partie de borne (50cg, 50dg, 50eg, 50ig), la partie d'extrémité étant située sur un côté opposé de la surface latérale (70c) du moule en résine (70), et
une partie de différence de niveau formée entre la première partie de borne (50cg, 50dg, 50eg, 50ig) et la deuxième partie de borne (50ch, 50dh, 50eh, 50ih), et dans lequel
l'élément de support (60, 60A, 60B) est situé à une limite entre la première partie de borne (50cg, 50dg, 50eg, 50ig) et la deuxième partie de borne (50ch, 50dh, 50eh, 50ih), et recouvre la partie de différence de niveau.

2. Module semi-conducteur (60a, 61a, 62a, 63a) selon la revendication 1, dans lequel
le matériau du moule en résine (70) est identique au matériau de l'élément de support (60, 60A, 60B).

3. Module semi-conducteur (60a, 61a, 62a, 63a) selon la revendication 1 ou la revendication 2, dans lequel
une forme de l'élément de support (60, 60A, 60B) est une forme de parallélépipède rectangle, et
l'élément de support (60, 60A, 60B) est disposé parallèlement à la surface latérale (70c) du moule en résine (70).

4. Module semi-conducteur (60a, 61a, 62a, 63a) selon l'une quelconque des revendications 1 à 3, dans lequel
une position centrale (P1) de l'élément de support (60, 60A, 60B) coïncide avec une position centrale (P2) de chacune de la pluralité des bornes externes (50c, 50d, 50e, 50i) dans une direction d'épaisseur de l'élément de support (60, 60A, 60B).

5. Module semi-conducteur (60a, 61a, 62a, 63a) selon l'une quelconque des revendications 1 à 4, dans lequel
chacune de la pluralité des bornes externes (50c, 50d, 50e, 50i) comporte une partie d'extrémité (50ie) située sur un côté opposé de la surface latérale (70c) du moule en résine (70), et
l'élément de support (60, 60A, 60B) est disposé plus près de la partie d'extrémité (50ie) que de la surface latérale (70c) du moule en résine (70).

6. Module semi-conducteur (60a, 61a, 62a, 63a) selon l'une quelconque des revendications 1 à 5, dans lequel
l'épaisseur de l'élément de support (60, 60A, 60B) est inférieure ou égale à l'épaisseur du moule en résine (70).

7. Module semi-conducteur (60a, 61a, 62a, 63a) selon l'une quelconque des revendications 1 à 6, dans lequel
chacune de la pluralité des bornes externes (50c, 50d, 50e, 50i) comporte
deux premières surfaces (F) parallèles à une direction orthogonale à une direction dans laquelle s'étendent la pluralité de bornes externes (50c, 50d, 50e, 50i) et à une direction dans laquelle la pluralité de bornes externes (50c, 50d, 50e, 50i) sont disposées, et
deux deuxièmes surfaces (S) parallèles à une direction dans laquelle la pluralité de bornes externes (50c, 50d, 50e, 50i) sont disposées, et dans lequel
l'élément de support (60, 60A, 60B) recouvre les deux premières surfaces (F) et les deux deuxièmes surfaces (S).

8. Module semi-conducteur (60a, 61a, 62a, 63a) selon l'une quelconque des revendications 1 à 7, dans lequel
chacune de la pluralité des bornes externes (50c, 50d, 50e, 50i) comporte une partie courbée (50cf, 50ef, 50if) située entre la surface latérale (70c) du moule en résine (70) et l'élément de support (60, 60A, 60B).

9. Module à semi-conducteur (60a, 61a, 62a, 63a) selon l'une quelconque des revendications 1 à 8, dans lequel
la pluralité des bornes externes (50c, 50d, 50e, 50i) comprend un premier groupe de bornes (55) et un deuxième groupe de bornes (56), le premier groupe de bornes (55) comprenant une pluralité de premières bornes externes (50i) ayant une première partie courbée (50if) située entre la surface latérale (70c) du moule en résine (70) et l'élément de support (60, 60A, 60B), le deuxième groupe de bornes (56) comprenant une pluralité de deuxièmes bornes externes (50c, 50d, 50e, 50i) ayant une deuxième partie courbée (50cf, 50df, 50ef, 50ii) située entre la surface latérale (70c) du moule en résine (70) et l'élément de support (60, 60A, 60B),
une distance entre la surface latérale (70c) du moule en résine (70) et la deuxième partie courbée (50ef) est supérieure à une distance entre la surface latérale (70c) du moule en résine (70) et la première partie courbée (50if),
l'élément de support (60, 60A, 60B) comprend un premier élément de support (60A) et un deuxième élément de support (60B) parallèles l'un à l'autre,
le premier élément de support (60A) fixe la pluralité des premières bornes externes (50i) de telle sorte que la pluralité des premières bornes externes (50i) du premier groupe de bornes (55) soient espacées les unes des autres, et
le deuxième élément de support (60B) fixe la pluralité des deuxièmes bornes externes (50c, 50d, 50e, 50i) de telle sorte que la pluralité des deuxièmes bornes externes (50c, 50d, 50e, 50i) du deuxième groupe de bornes (56) soient espacées les unes des autres.

10. Module semi-conducteur (60a, 61a, 62a, 63a) selon l'une quelconque des revendications 1 à 8, dans lequel
la pluralité de bornes externes (50c, 50d, 50e, 50i) comprend un premier groupe de bornes (55) et un deuxième groupe de bornes (56), le premier groupe de bornes (55) comprenant une pluralité de premières bornes externes (50i) ayant une première partie courbée (50if) située entre la surface latérale (70c) du moule en résine (70) et l'élément de support (60, 60A, 60B), le deuxième groupe de bornes (56) comprenant une pluralité de deuxièmes bornes externes (50c, 50d, 50e, 50i) ayant une deuxième partie courbée (50ef) située entre la surface latérale (70c) du moule en résine (70) et l'élément de support (60, 60A, 60B),
une distance entre la surface latérale (70c) du moule en résine (70) et la deuxième partie courbée () est supérieure à une distance entre la surface latérale (70c) du moule en résine (70) et la première partie courbée (50if),
l'élément de support (60, 60A, 60B) fixe : la pluralité de premières bornes externes (50i) de telle sorte que la pluralité de premières bornes externes (50i) du premier groupe de bornes (55) soient espacées les unes des autres ; et la pluralité de deuxièmes bornes externes (50c, 50d, 50e, 50i) de telle sorte que la pluralité de deuxièmes bornes externes (50c, 50d, 50e, 50i) du deuxième groupe de bornes (56) soient espacées les unes des autres.
